## Europäisches Patentamt
## European Patent Office
## Office européen des brevets

(19)

(11) Publication number: **0 021 719**
**B1**

(12)

# EUROPEAN PATENT SPECIFICATION

(45) Date of publication of patent specification: **16.05.84**

(51) Int. Cl.³: **G 03 F 7/08**

(21) Application number: **80301958.7**

(22) Date of filing: **11.06.80**

(54) Method for producing negative resist images, and resist images.

(30) Priority: **18.06.79 JP 76562/79**

(43) Date of publication of application:
**07.01.81 Bulletin 81/01**

(45) Publication of the grant of the patent:
**16.05.84 Bulletin 84/20**

(84) Designated Contracting States:
**DE FR GB NL**

(56) References cited:
**DE-A-2 461 912**
**FR-A-2 316 625**
**US-A-4 104 070**

(73) Proprietor: **FUJITSU LIMITED**
**1015, Kamikodanaka Nakahara-ku**
**Kawasaki-shi Kanagawa 211 (JP)**

(72) Inventor: **Nakagawa, Takayuki**
**66, Bunka-cho Shimodate-shi**
**Ibaraki 308 (JP)**

(74) Representative: **Allman, Peter John et al**
**Marks and Clerk Scottish Life House Bridge**
**Street**
**Manchester M3 3DP (GB)**

Courier Press, Leamington Spa, England.

## Description

The present invention relates to a method for producing negative resist images using a diazo-type resist material.

It is well known that a diazo-type resist material consisting essentially of a phenol-formaldehyde novolak resin containing about 10% by weight of a naphthoquinon diazide forms a photosensitive film usable for producing a positive resist image by irradiation of the film with ultraviolet radiation in a desired pattern. On the other hand, conventional negative resist materials generally have a drawback in that, in the case where a fine pattern is to be formed, undesirable bridging between the pattern-composing lines may occur in the resulting image.

Another photoresist system had been suggested in US—A—4 104 070 which relates to a method of making a negative working photoresist image on a substrate where a normally positive working photoresist material containing 1-hydroxyethyl-2-alkylimidazoline is applied to a substrate, imagewise exposed with actinic radiation heated, and blanket exposed to actinic radiation. The material which was not exposed originally is then removed with a solvent to give a negative image. In this method, the photoresist layer is exposed by a mercury high pressure lamp.

It has now been found that a diazo-type resist material as mentioned above can advantageously be used as a negative resist material for producing a fine resist pattern under a specific condition as hereinbelow defined.

According to the present invention there is provided a method for producing a negative resist image, comprising exposing a film of a diazo-type resist material to electron beam radiation in a predetermined pattern, heat treating said patternwise exposed resist film, subjecting said heat treated film to overall exposure to ultraviolet radiation and, then, developing the so treated film to remove the resist material in the area not exposed to electron beam radiation, characterised in that the resist material is free from 1-hydroxyethyl-2-alkylimidazoline, said patternwise exposure to electron beam radiation is carried out at a current density of not more than 40 A/cm², said electron beam exposure is to a radiation dose such that about 70% of the resist film thickness is retained in the area exposed to electron beam radiation after the development of the film, said heat treatment is carried out at a temperature of not higher than 100°C, and said overall ultraviolet exposure is to a radiation dose of 100 to 400 mW · sec/cm².

A diazo-type resist material consisting essentially of a phenol-formaldehyde novolak resin containing about 10% by weight of a naphthoquinone diazide can advantageously be utilized as a negative resist material which has a resolving power much superior to those of conventional negative resist materials and which produces a resist mask having excellent resistance to dry etching operations in the manufacturing of microcircuits. Further, since such a diazo-type resist material can, of course, be employed as a usual positive resist material, a film of such a diazo-type resist material can be used for producing both a positive resist image by a conventional method and a negative resist image by the method of the present invention.

The present invention will further be illustrated below using AZ 1350 J (trade mark, Shipley Inc.) as an example of the diazo-type resist material.

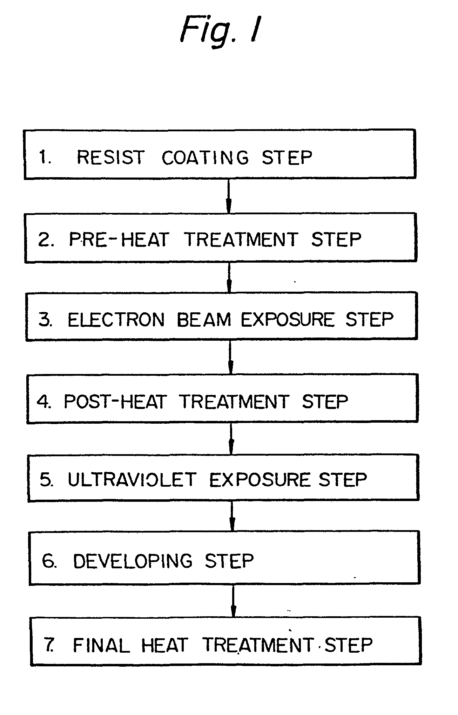

Fig. 1 indicates the steps in a process for practicing the method of the present invention. Referring to Fig. 1, in a resist coating step 1, AZ 1350 J is coated on a substrate to produce a resist film. After the resist coating step, the coated resist film is heat treated appropriately at a temperature of 80 to 95°C, for 20 min., in a pre-heat treatment step 2. A pre-heat treatment at a higher temperature may disadvantageously result in the lowering of the solubility of the film in a developer, in the area not exposed to electron beam radiation, when the film is developed.

The resist film is then exposed to electron beam radiation in a predetermined pattern in an electron beam exposure step 3. If the irradiation of the film with electron beam radiation is carried out at a high radiation dose, there may be obtained an advantage that the film is dissolved in a developer at a rate smaller than the dissolving rate of a film irradiated with electron beam radiation at a low radiation dose. However, there may occur a disadvantage in that a long exposure time is necessary. This is because the exposure time (t sec.) is given by the equation,

$$t = \frac{B}{A}$$

in which B is an electron beam radiation dose (coulomb/cm²), and A is a current density (ampere/cm²). Therefore if the current density A is kept constant while the electron beam radiation dose is increased, the exposure time becomes longer. Further, if the film is irradiated at a high radiation dose, there may occur a disadvantage in that fogging is produced due to the scattering of electrons. Therefore, the irradiation of the resist film with electron beam radiation may appropriately be effected to a radiation dose such that about 70% of the resist film thickness is retained in the area of the film exposed to electron beam radiation after the development of the film.

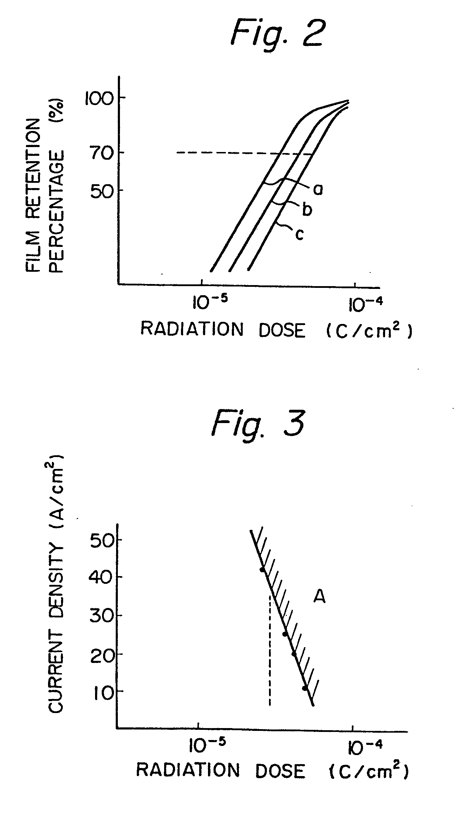

Fig. 2 is a graph illustrating a relationship between the film retention percentage (%) and the electron beam radiation dose (coulomb/cm²). The "film retention percentage" refers to the percentage of the film thickness in the area exposed to electron beam radiation after development to the film thickness before development. In the figure, curve a shows a case where the heat treatment after the electron beam exposure was carried out at 100°C, curve b shows a case where the heat treatment after the electron beam exposure was carried out at 80°C, and curve c shows a case where the heat treatment after the electron beam exposure was not carried out.

If the diazo-type resist material is irradiated excessively by electron beam radiation, so called "bubbling" occurs in the resist film. In Fig. 3, there is shown an area A in which the bubbling occurs in relation to the current density (ampere/cm$^2$) and the electron beam radiation dose (coulomb/cm$^2$). In this case, the pre-heat treatment was carried out at 80°C and the heat treatment after the electron beam exposure was carried out at 100°C.

Referring again to Fig. 1, after the electron beam exposure step, the film is subjected to a post-heat treatment step 4. In this step, the heat treatment may be appropriately carried out at a temperature of not higher than 100°C for about 20 min. If the heat treatment is carried out at a temperature higher than 100°C, the resulting resist image may often have a drawback in that the image is inferior in sharpness.

The treated film is then subjected to overall exposure to ultraviolet radiation in an ultraviolet exposure step 5. The irradiation may preferably be effected at a radiation dose of 100 to 400 mW · sec/cm$^2$. Then, the film is developed in an alkaline developer MF312 (trade mark, Shipley Inc.) in a developing step 6. Preferably, the developer is diluted by an equal amount of water. After the developing step, the film is heat treated in final heat treatment step 7.

Example

A diazo-type resist material, AZ 1350 J, was coated on an aluminum surface of a silicon wafer (500 $\mu$m), on which a silica layer (0.5 $\mu$m) and then an aluminum layer (1 $\mu$m) were grown, by a spin coater and heat treated in an air oven at 80°C for 20 min. to obtain a dry resist film of 1.2 $\mu$ on the support. The film was then exposed to electron beam radiation, in a desired pattern, in a vacuum at a current density of 30 ampere/cm$^2$ and, then, baked in an air oven, at 90°C, for 20 min. The film was then exposed to ultraviolet radiation in a photo-aligner at 300 mW · sec/cm$^2$. Then, the film was developed in an alkaline developer containing equal amounts of MF 312 and water. Thus, a negative resist image of a fine pattern was obtained.

The resulting resist mask was superior to resist masks obtained from conventional electron beam resist materials, in the resistance to dry etching operations, and the aluminum layer of the substrate on which said resist mask was formed could be etched in a gas based on BCl$_3$ or CCl$_4$.

**Claim**

A method for producing a negative resist image, comprising exposing a film of a diazo-type resist material to electron beam radiation in a predetermined pattern, heat treating said patternwise exposed resist film, subjecting said heat treated film to overall exposure to ultraviolet radiation and, then, developing the so treated film to remove the resist material in the area not exposed to electron beam radiation, characterised in that the resist material is free from 1-hydroxyethyl-2-alkylimidazoline, said patternwise exposure to electron beam radiation is carried out at a current density of not more than 40 A/cm$^2$, said electron beam exposure is to a radiation dose such that about 70% of the resist film thickness is retained in the area exposed to electron beam radiation after the development of the film, said heat treatment is carried out at a temperature of not higher than 100°C, and said overall ultraviolet exposure is to a radiation dose of 100 to 400 mW · sec/cm$^2$.

**Patentanspruch**

Verfahren zur Herstellung eines negative Resistbildes, bei welchem ein Film aus Resist-material von Diazotyp einer Elektronenstrahl-bestrahlung in einem vorbestimmten Muster ausgesetzt wird, der musterweise bestrahlte Resistfilm mit Wärme behandelt wird, der wärmebehandelte Film einer Gesamt-belichtung durch ultraviolette Strahlung ausge-setzt und dann der so behandelte Film entwickelt wird, um das Resistmaterial in dem Bereich zu entfernen, welcher nicht der Elektronenstrahlbestrahlung ausgesetzt war, dadurch gekennzeichnet, daß das Resistmaterial frei ist von 1-Hydroxyäthyl-2-alkylimidazoline, die musterartige Belichtung mit Elektronenstrahlbestrahlung bei einer Stromdichte von nicht mehr als 40 A/cm$^2$ durchgeführt wird, die Elektronenstrahlbelichtung mit bis zu einer solchen Strahlungsdosis erfolgt, daß ungefähr 70% der Resistfilmdicke in dem der Elektronenstrahlbestrahlung ausgesetzten Bereich nach der Entwicklung des Films zurückgehalten wird, die Wärmebehandlung bei einer Temperatur von nicht mehr als 100°C durchgeführt wird, und die Gesamtbestrahlung mit ultraviolettem Licht mit einer Strahlungsdosis bis zu 100 bis 400 mW · cm$^2$ beträgt.

**Revendication**

Procédé pour produire une image négative dans une matière de réserve, selon lequel on expose un film d'une matière de réserve type diazo à un faisceau d'électrons selon un motif prédéterminé, on applique un traitement thermique au film de matière de réserve exposé selon ce motif, on expose l'ensemble du film ainsi traité à un rayonnement ultraviolet puis on développe le film pour enlever la matière de réserve de la zone non exposée au faisceau d'électrons, caractérisé en ce que la matière de réserve est exempte de 1-hydroxyéthyl-2-alkyl-imidazole, on effectue l'exposition au faisceau d'électrons selon le motif avec une densité de courant ne dépassant pas 40 A/cm² et avec un débit d'exposition tel qu'environ 70% de l'épaisseur du film de matière de réserve soient retenus dans la zone exposée au faisceau après le développement du film, on effectue le traitement thermique à une température de tout au plus 100°C et on réalise l'exposition globale au rayonnement ultraviolet avec un débit d'exposition de 100 à 400 mW·s/cm².

# Fig. I

| 1. RESIST COATING STEP |
| --- |

| 2. PRE-HEAT TREATMENT STEP |
| --- |

| 3. ELECTRON BEAM EXPOSURE STEP |
| --- |

| 4. POST-HEAT TREATMENT STEP |
| --- |

| 5. ULTRAVIOLET EXPOSURE STEP |
| --- |

| 6. DEVELOPING STEP |
| --- |

| 7. FINAL HEAT TREATMENT STEP |
| --- |

# Fig. 2

# Fig. 3